# EUROPEAN PATENT APPLICATION

(11) **EP 4 354 509 A1**
(43) Date of publication of application: **17.04.2024**
(21) Application number: 23201964.6
(22) Date of filing: 05.10.2023
(51) Int. Cl.: H01L 29/06, H01L 21/329, H01L 29/861, H01L 23/31

(54) **POWER DIODE DEVICE AND METHOD OF MANUFACTURING THE SAME**

(30) Priority: 12.10.2022 TW 111138688; 02.06.2023 US 202318205288
(71) Applicant: Diodes Incorporated, Plano, Texas 75024 (US)
(72) Inventor: Tseng, Ching Chiu, Keelung City (TW); Lo, Tzu Yuan, Keelung City (TW); Chang, Chao Yi, Keelung City (TW)
(74) Representative: Marks & Clerk LLP

(57) **Abstract**

A power diode device includes a substrate. The substrate includes a core layer of a first conductive type, a first diffusion layer of the first conductive type, a second diffusion layer of a second conductive type, and a heavily doped region of the second conductive type. The core layer is located between the first diffusion layer and the second diffusion layer. A thickness of the core layer is greater than that of the second diffusion layer. The heavily doped region is located in the second diffusion layer and extends toward the core layer to form a PN junction between the heavily doped region and the core layer. A method for manufacturing the power diode device is also provided.

## Description

### CROSS REFERENCE TO RELATED APPLIATIONS

This patent application claims priority to Taiwan Application No. 111138688, filed on October 12, 2022 and entitled "POWER DIODE DEVICE AND METHOD OF MANUFACTURING THE SAME," which is hereby incorporated by reference herein as if reproduced in its entirety.

### TECHNICAL FIELD

The present disclosure relates to the field of power diodes, and in particular embodiments, to a power diode device and method of manufacturing the same.

### BACKGROUND

A conventional power diode may have a mesa structure to define an active region and a junction termination. The mesa structure can be formed by etching the sides of the substrate through an etching process. Since the upper half of the substrate is used to form a mesa, the thickness is small and the structural strength is reduced. In addition, if the gradient of the side surface of the mesa cannot be precisely controlled during the etching process, the electrical performance of the power diode may be affected, for example, the breakdown voltage is not high enough.

It is also possible to use a power diode with a planar structure, and form a guard ring to relax the electric field distribution, to increase the breakdown voltage of the power diode. However, for power diodes with high voltage (for example, voltage greater than 600 V), in order to further increase the breakdown voltage, the number of guard rings needs to be increased, but the number of guard rings is limited by the line width capability of the process. In addition, the larger the number of the guard rings, the more the proportion of the area occupied by the guard rings, which is not conducive to the reduction of the device size, and increases the manufacturing cost.

### SUMMARY

Technical advantages are generally achieved, by embodiments of this disclosure which describe a power diode device and method of manufacturing the same.

Embodiments of the present disclosure relate to a power diode device. The power diode device includes a substrate, which includes: a core layer of a first conductivity type, a first diffusion layer of the first conductivity type, a second diffusion layer of a second conductivity type, and a heavily doped region of the second conductivity type. The core layer has a first surface and a second surface opposite to the first surface of the core layer. The first diffusion layer has a first surface and a second surface opposite to the first surface of the first diffusion layer. The second diffusion layer has a first surface and a second surface opposite to the first surface of the second diffusion layer. The thickness of the core layer is greater than the thickness of the second diffusion layer. The core layer is located between the first diffusion layer and the second diffusion layer, such that the first surface of the core layer faces the second surface of the first diffusion layer, the second surface of the core layer faces the first surface of the second diffusion layer, the second surface of the second diffusion layer forms the top surface of the substrate, and the first surface of the first diffusion layer forms the bottom surface of the substrate. The heavily doped region has a first surface and a second surface opposite to the first surface of the heavily doped region. The second surface of the heavily doped region is coplanar with the second surface of the second diffusion layer, and the heavily doped region extends toward the core layer such that the first surface of the heavily doped region reaches the second surface of the core layer, or reaches in-between the first surface of the core layer and the second surface of the core layer but without reaching the first surface of the core layer, such that the heavily doped region and the core layer form a first PN junction.

Embodiments of the present disclosure relate to a manufacturing method of a power diode device. The manufacturing method includes forming a first diffusion layer of a first conductivity type in a substrate of the first conductivity type. The first diffusion layer has a first surface and a second surface opposite to the first surface of the first diffusion layer. The first surface of the first diffusion layer forms the bottom surface of the substrate. The manufacturing method further includes forming a second diffusion layer of a second conductivity type in the substrate, where the second diffusion layer has a first surface and a second surface opposite to the first surface of the second diffusion layer, and the second surface of the second diffusion layer forms the top surface of the substrate. The first diffusion layer is not in contact with the second diffusion layer, and the portion between the first diffusion layer and the second diffusion layer is a core layer. The manufacturing method further includes forming a heavily doped region of the second conductivity type in the second diffusion layer. The heavily doped region has a first surface and a second surface opposite to the first surface of the heavily doped region, and the second surface of the heavily doped region is coplanar with the top surface of the substrate. The manufacturing method also includes diffusing the heavily doped region towards the core layer to form a first PN junction between the heavily doped region and the core layer.

According to one aspect of the present application, a power diode device is provided that includes a substrate. The substrate includes: a first diffusion layer of a first conductivity type, the first diffusion layer comprising a first surface and a second surface opposite to each other, and the first surface of the first diffusion layer forming a bottom surface of the substrate; a second diffusion layer of a second conductivity type, the second diffusion layer comprising a first surface and a second surface opposite to each other, and the second surface of the second diffusion layer forming a top surface of the substrate; a core layer of the first conductivity type between the first diffusion layer and the second diffusion layer, the core layer comprising a first surface and a second surface opposite to each other, the first surface of the core layer facing the first diffusion layer, the second surface of the core layer facing the second diffusion layer, and a thickness of the core layer being greater than a thickness of the second diffusion layer; and a heavily doped region of the second conductivity type in the second diffusion layer and extending toward the core layer, the heavily doped region comprising a first surface and a second surface opposite to each other, the second surface of the heavily doped region being coplanar with the second surface of the second diffusion surface, the first surface of the heavily doped region reaching the second surface of the core layer or reaching in-between the first surface of the core layer and the second surface of the core layer without reaching the first surface of the core layer, wherein a first PN junction is formed between the heavily doped region and the core layer.

According to another aspect of the present application, a method for making a power diode is provided. The method includes: forming a first diffusion layer of a first conductivity type in a substrate of the first conductivity type, the first diffusion layer comprising a first surface and a second surface opposite to each other, and the first surface of the first diffusion layer forming a bottom surface of the substrate; forming a second diffusion layer of a second conductivity type in the substrate, with a core layer located between the second diffusion layer and the first diffusion layer, the second diffusion layer comprising a first surface and a second surface opposite to each other, and the second surface of the second diffusion layer forming a top surface of the substrate; forming a heavily doped region of the second conductivity type in the second diffusion layer, the heavily doped region comprising a first surface and a second surface opposite to each other, and the second surface of the heavily doped region being coplanar with the top surface of the substrate; and diffusing the heavily doped region into the core layer to form a first PN junction between the heavily doped region and the core layer.

According to another aspect of the present application, a power diode is provided that includes: a first diffusion layer of a first conductivity type in a substrate, the first diffusion layer comprising a first surface and a second surface opposite to each other, and the first surface of the first diffusion layer being a bottom surface of the substrate; a second diffusion layer of a second conductivity type in the substrate, the second diffusion layer comprising a first surface and a second surface opposite to each other, and the second surface of the second diffusion layer being a top surface of the substrate; a core layer of the first conductivity type between the first diffusion layer and the second diffusion layer, the core layer comprising a first surface and a second surface opposite to each other, the first surface of the core layer facing the first diffusion layer, and the second surface of the core layer facing the second diffusion layer; a heavily doped region of the second conductivity type in the second diffusion layer, the heavily doped region extending into the core layer without reaching the first surface of the core layer, with a first PN junction formed between the heavily doped region and the core layer; and an isolation structure separated from the heavily doped region by the second diffusion layer.

Advantages of the aspects of the present application include improved wafer strength, electric field distribution, breakdown voltage and terminal length, reduced die size and masks, simplified process and decreased cost. The aspects of the present application may be applied for high voltage power diode devices.

### BRIEF DESCRIPTION OF THE DRAWINGS

Embodiments of the present disclosure may be better understood from the following detailed description when read with accompanying drawings. It should be noted that the various structures may not be drawn to scale. In fact, the dimensions of the various structures may be arbitrarily enlarged or reduced for clarity of discussion.

The technical solutions and beneficial effects of the present application will be made apparent through the detailed description of embodiments of the present application in conjunction with the accompanying drawings, in which:
FIG. 1 is a cross-sectional view of a power diode device according to embodiments of the present disclosure;
FIG. 2A is a diagram depicting an enlarged view of a portion of a power diode device according to embodiments of the present disclosure;
FIG. 2B is a graph depicting electric field intensity of the power diode element in FIG. 2A along a cutting line X; and
FIGs. 3A - 3G are diagrams showing one or more stages in a manufacturing method of a power diode device according to embodiments of the present disclosure.

Brief explanation of reference signs in the drawings: 1: power diode device; 2a: a portion of the power diode device; 10: substrate; 10a: diffusion layer; 10a1: surface; 10ah: thickness; 10b: core layer; 10b1: surface; 10b2: surface; 10b2': surface; 10bh: thickness; 10c: diffusion layer; 10c2: surface; 10ch: thickness; 10h: thickness; 10h': thickness; 11: heavily doped region; 112: surface; 11h: depth; 12: isolation structure; 12h: depth; 13: electrode layer; 14: passivation layer; 14a: oxide layer; 14b: nitride layer; 14c: oxide layer; 14d: insulating layer; 15: electrode layer; 30: protective layer; 30h: opening; 31: protective layer; 31h: opening; 32: protective layer; D1: distance; D2: distance; DR: depleted extended region; L1: position; L2: position; P1: peak; P2: peak; S1: PN junction; S2: PN junction; S3: PN junction, X: cutting line.

The same or similar components are labeled with the same reference numerals in the drawings and detailed description. Several embodiments of the present disclosure will be readily understood from the following detailed description taken in conjunction with the accompanying drawings.

### DETAILED DESCRIPTION OF ILLUSTRATIVE EMBODIMENTS

The making and using of embodiments of this disclosure are discussed in detail below. It should be appreciated, however, that the concepts disclosed herein can be embodied in a wide variety of specific contexts, and that the specific embodiments discussed herein are merely illustrative and do not serve to limit the scope of the claims. Further, it should be understood that various changes, substitutions and alterations can be made herein without departing from the spirit and scope of this disclosure as defined by the appended claims.

The following disclosure provides various different embodiments or examples for implementing different features of the presented subject matter. Specific embodiments of components and configurations are described below. Certainly, these are examples only and are not intended to be limiting. In this disclosure, references to forming a first feature over or on a second feature may include embodiments where the first and second features are formed in direct contact, and may also include embodiments where an additional feature is formed between the first feature and the second feature such that the first feature and the second feature may not be in direct contact. In addition, the present disclosure may repeat reference signs and/or letters in various embodiments. Such repetition is for simplicity and clarity and does not in itself indicate a relationship between the various embodiments and/or configurations discussed.

Embodiments of the present disclosure are discussed in detail below. It should be appreciated, however, that the present disclosure provides applicable concepts that can be embodied in a wide variety of specific contexts. The specific embodiments discussed herein are illustrative only, and do not limit the scope of the present disclosure.

The present disclosure provides a power diode device and a manufacturing method thereof. Compared with power diode devices having a mesa structure, the power diode device of the present disclosure has a higher structural strength. In addition, compared with power diode devices that form guard rings to relax the electric field distribution, the power diode device of the present disclosures is not limited by the line width capability of the process, has a shorter terminal length, and is thus conducive to reduction of the device size.

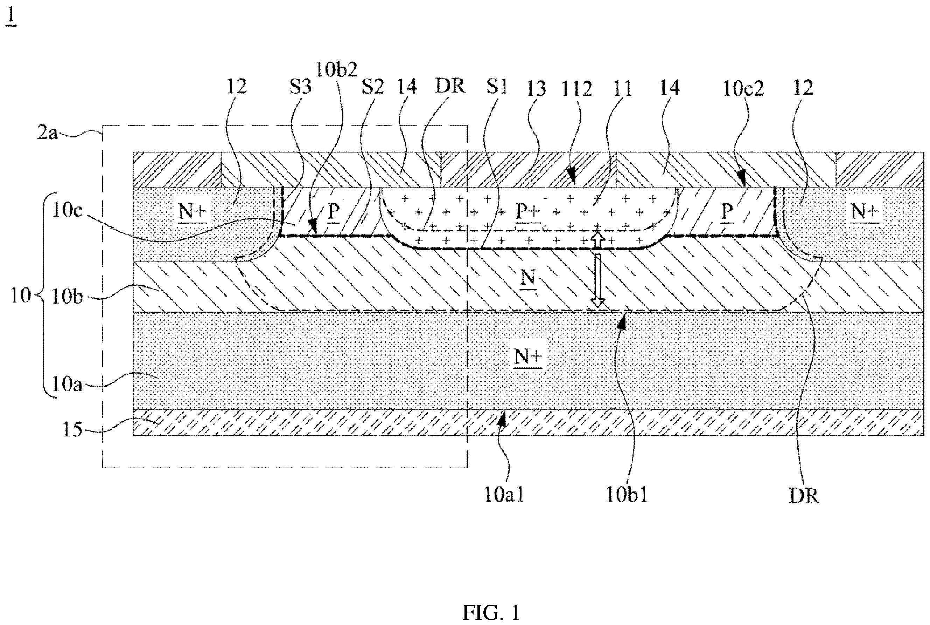

Referring to FIG. 1, FIG. 1 is a cross-sectional view of a power diode device 1 according to embodiments of the present disclosure. The power diode device 1 may include a substrate 10, a heavily doped region 11, an isolation structure 12, an electrode layer 13, a passivation layer 14 and an electrode layer 15.

The substrate 10 may include a semiconductor substrate. The substrate 10 may include a semiconductor material such as (but not limited to) silicon (Si), gallium nitride (GaN), gallium arsenide (GaAs), aluminum nitride (AlN), silicon carbide (SiC), indium phosphide (InP), zinc selenide (ZnSe) or other semiconductor materials of group VI, III-V or II-VI. In some embodiments, an N-type monocrystalline silicon wafer having a volume resistivity between about 45 and about 60 Ohm-cm may be used to form the substrate 10. The substrate 10 may include a first diffusion layer 10a (hereinafter referred to as a diffusion layer 10a), a core layer 10b and a second diffusion layer 10c (hereinafter referred to as a diffusion layer 10c).

The core layer 10b may be located between the diffusion layer 10a and the diffusion layer 10c. For example, the core layer 10b may be sandwiched between the diffusion layer 10a and the diffusion layer 10c. The core layer 10b may be a part of the original semiconductor substrate. The core layer 10b can be doped with N-type impurities, e.g., the region marked with "N " in FIG. 1. The N-type impurities may include pentavalent elements such as phosphorus, arsenic, antimony, and so on. In other embodiments, the core layer 10b may be doped with P-type impurities, such as trivalent elements, e.g., boron, aluminum, gallium, and so on. The core layer 10b may include a first surface 10b1 (hereinafter referred to as the surface 10b1) and a second surface 10b2 (hereinafter referred to as the surface 10b2) opposite to the surface 10b1. The surface 10b1 of the core layer 10b faces the diffusion layer 10a, and the surface 10b2 of the core layer 10b faces the diffusion layer 10c.

The diffusion layer 10a may include a semiconductor layer doped with N-type impurities. The diffusion layer 10a and the core layer 10b can have the same conductivity type, but the impurity concentration of the diffusion layer 10a can be higher than that of the core layer 10b. For this reason, the diffusion layer 10a is shown as a region marked with " N+ " in FIG. 1. In the present disclosure, a " N+ " region or " P+ " region has an impurity concentration higher than its adjacent regions. The diffusion layer 10a may include a first surface 10a1 (hereinafter referred to as the surface 10a1) and a second surface (not shown in the figure, which faces the surface 10b1 of the core layer 10b). The surface 10a1 of the diffusion layer 10a forms the bottom surface of the substrate 10.

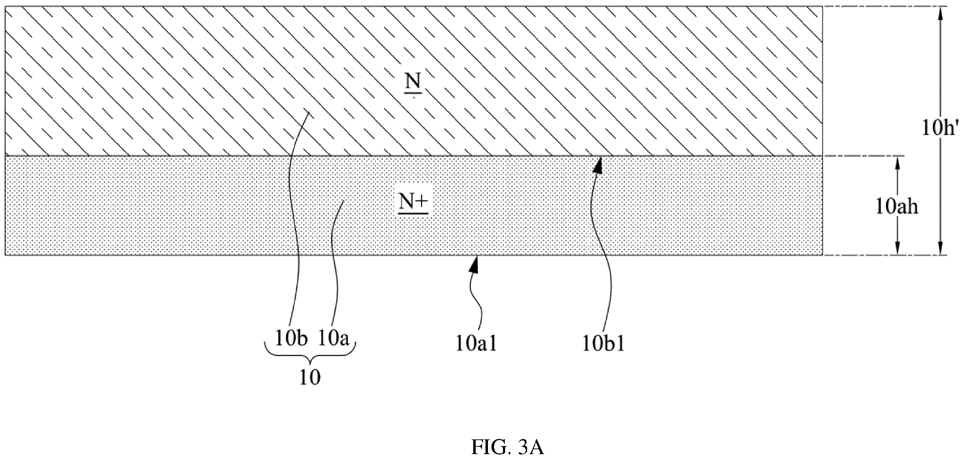

In some embodiments, the diffusion layer 10a may be formed by diffusing N-type impurities from the bottom surface of the substrate 10 into the core layer 10b (e.g., as shown in FIG. 3A). In some embodiments, a diffusion boundary may be formed between the diffusion layer 10a and the core layer 10b. In some embodiments, the diffusion boundary between the diffusion layer 10a and the core layer 10b is a boundary between a high-concentration N-type impurity (N+) region and an N-type impurity (N) region.

The diffusion layer 10c may include a semiconductor layer doped with P-type impurities, e.g., the region marked with "P" in FIG. 1. The diffusion layer 10c and the core layer 10b may have opposite conductivity types. The diffusion layer 10c and the diffusion layer 10a may have opposite conductivity types. The diffusion layer 10c may include a first surface (not shown in the figure, which faces the surface 10b2 of the core layer 10b) and an opposite second surface 10c2 (hereinafter referred to as the surface 10c2). The surface 10c2 of the diffusion layer 10c forms the top surface of the substrate 10. That is, the surface 10c2 of the diffusion layer 10c and the surface 10a1 of the diffusion layer 10a may be two opposite surfaces of the substrate 10.

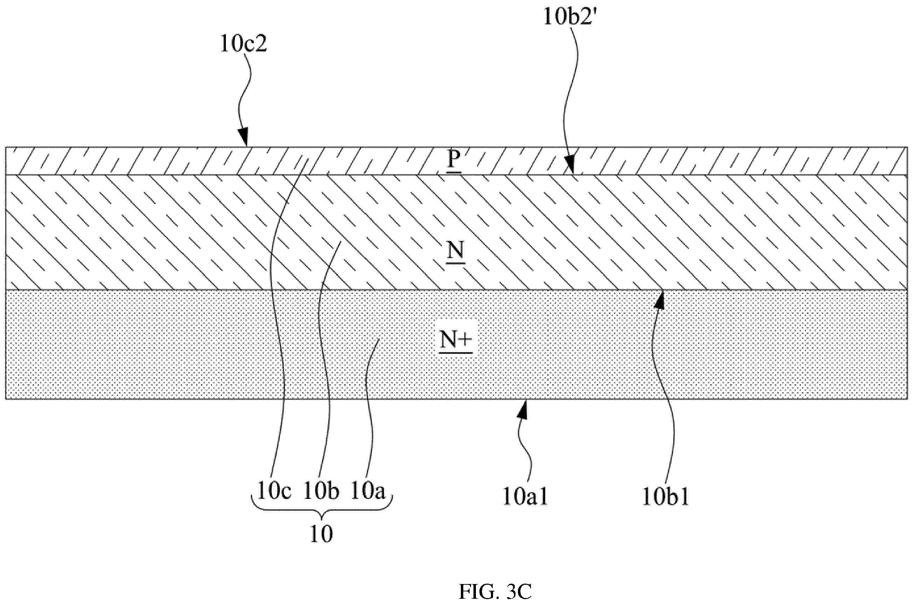

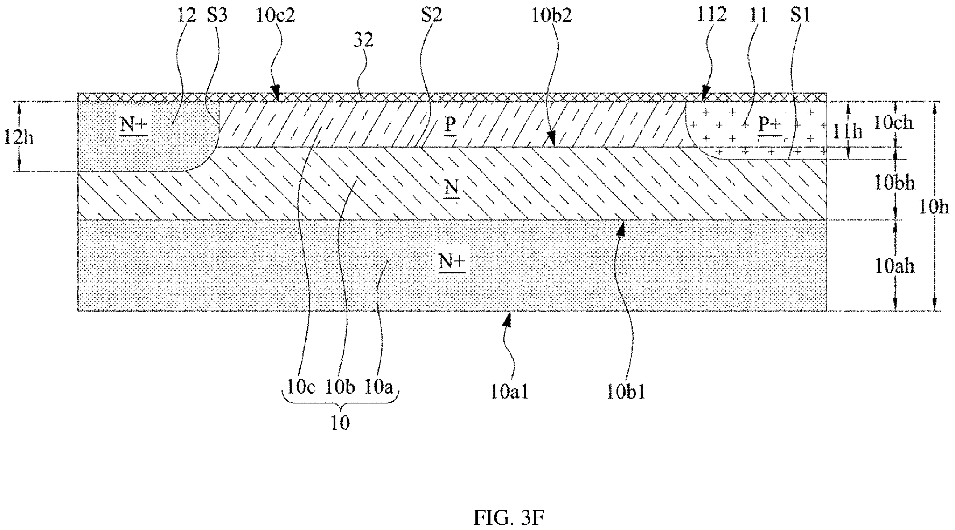

In some embodiments, the diffusion layer 10c may be formed by inverting a part of the N-type core layer 10b from the top surface of the substrate 10 to a P-type (e.g., as shown in FIG. 3C) and then performing diffusion (e.g., shown in FIG. 3F). For example, in some embodiments, the diffusion layer 10c may diffuse into the core layer 10b simultaneously with the heavily doped region 11 during the diffusion of the heavily doped region 11, and form a diffusion boundary with the core layer 10b. In some embodiments, the diffusion boundary between the diffusion layer 10c and the core layer 10b is a boundary between a P-type impurity (P) region and an N-type impurity (N) region or is a PN junction S2.

The heavily doped region 11 may be located in the substrate 10. In some embodiments, the heavily doped region 11 may be surrounded by the diffusion layer 10c. For example, the heavily doped region 11 may be located in the diffusion layer 10c. For example, when viewed from the cross-sectional view, the heavily doped region 11 may be located between two diffusion layers 10c on the left side and the right side.

The heavily doped region 11 may include a semiconductor layer doped with P-type impurities. The heavily doped region 11 and the diffusion layer 10c may have the same conductivity type, but the impurity concentration of the heavily doped region 11 may be higher than that of the diffusion layer 10c. For this reason, the heavily doped region 11 is marked as a "P + " region in FIG. 1.

In some embodiments, the heavily doped region 11 may be formed by diffusing P-type impurities from the top surface of the substrate 10 into the core layer 10b (e.g., as shown in FIG. 3F). In some embodiments, a diffusion boundary may be formed between the heavily doped region 11 and the core layer 10b. In some embodiments, the diffusion boundary between the heavily doped region 11 and the core layer 10b is a boundary between a P-type impurity (P) region and an N-type impurity (N) region or a PN junction S1.

In some embodiments, the PN junction S1 between the heavily doped region 11 and the core layer 10b may be referred to as the first PN junction, and the PN junction S2 between the diffusion layer 10c and the core layer 10b may be referred to as the second PN junction. In some embodiments, the PN junction S2 and the PN junction S1 may be continuous junctions. In some embodiments, the PN junction S1 protrudes over the PN junction S2 in the direction from the top surface of the substrate 10 to the bottom surface of the substrate 10.

The heavily doped region 11 may include a first surface (located at the same position as the PN junction S1) and an opposite second surface (hereinafter referred to as the surface 112). The surface 112 may be coplanar with surface 10c2 of diffusion layer 10c. In other words, the surface 112 can be coplanar with the top surface of the substrate 10.

In some embodiments, the heavily doped region 11 may extend toward the core layer 10b, and its first surface (located at the same position as the PN junction S1) may reach the surface 10b2 of the core layer 10b. For example, the PN junction S1 may be coplanar with the surface 10b2 of the core layer 10b. In some embodiments, the heavily doped region 11 may extend toward the core layer 10b, and its first surface (located at the same position as the PN junction S1) may reach in-between the surface 10b2 and the surface 10b1 of the core layer 10b, but without reaching the surface 10b1. For example, the PN junction S1 may be located between the surface 10b2 and the surface 10b1 of the core layer 10b. For example, the PN junction S1 may extend beyond the surface 10b2 but not beyond the surface 10b1.

The isolation structure 12 may be located in the substrate 10. The isolation structure 12 may include a semiconductor layer doped with N-type impurities. The isolation structure 12 and the core layer 10b may have the same conductivity type, but the impurity concentration of the isolation structure 12 may be higher than the impurity concentration of the core layer 10b, and for this reason, the isolation structure 12 is marked as a " N+ " region in FIG. 1.

In some embodiments, the isolation structure 12 may surround the diffusion layer 10c. In some embodiments, the isolation structure 12 may surround the heavily doped region 11. For example, when viewed from the cross-sectional view, the heavily doped region 11 may be located between two isolation structures 12 on the left and right sides. The diffusion layer 10c may separate the heavily doped region 11 from the two isolation structures 12 on the left and right sides. For example, a diffusion layer 10c may be located between the heavily doped region 11 and an isolation structure 12.

In some embodiments, the isolation structure 12 may be formed by diffusing N-type impurities from the top surface of the substrate 10 into the core layer 10b (e.g., as shown in FIG. 3F). In some embodiments, a diffusion boundary may be formed between the isolation structure 12 and the diffusion layer 10c. In some embodiments, the diffusion boundary between the isolation structure 12 and the diffusion layer 10c may be a boundary between an N-type impurity (N) region and a P-type impurity (P) region or a PN junction S3. In some embodiments, the PN junction S3 between the isolation structure 12 and the diffusion layer 10c may be referred to as the third PN junction. In some embodiments, the PN junction S3 and the PN junction S2 may be continuous junctions.

In some embodiments, a diffusion boundary may be formed between the isolation structure 12 and the core layer 10b. In some embodiments, the diffusion boundary between the isolation structure 12 and the core layer 10b is a boundary between a high-concentration N-type impurity (N+) region and an N-type impurity (N) region.

In some embodiments, the isolation structure 12 and the heavily doped region 11 may be diffused simultaneously. For example, the isolation structure 12 and the heavily doped region 11 may be formed in the same step. In some embodiments, the isolation structure 12 may extend toward the core layer 10b, and one surface of the isolation structure 12 may reach the surface 10b2 of the core layer 10b. For example, the diffusion boundary between the isolation structure 12 and the core layer 10b may be coplanar with the surface 10b2 of the core layer 10b. In some embodiments, the isolation structure 12 may extend toward the core layer 10b, and one surface of the isolation structure 12 may reach in-between the surface 10b2 and the surface 10b1 of the core layer 10b without reaching the surface 10b1. For example, the diffusion boundary of the isolation structure 12 and the core layer 10b may be located in-between the surface 10b2 and the surface 10b1 of the core layer 10b. For example, the diffusion boundary of the isolation structure 12 and the core layer 10b may go beyond the surface 10b2 but not beyond the surface 10b1.

The electrode layer 15 (or referred to as the first electrode layer 15) may be located on the bottom surface of the substrate 10. For example, the electrode layer 15 may be disposed on the surface 10a1 of the diffusion layer 10a. For example, the electrode layer 15 may be in contact with or cover a portion of the diffusion layer 10a. For example, the electrode layer 15 may completely cover the surface 10a1 of the diffusion layer 10a. The electrode layer 15 may be regarded as an electrical terminal of the power diode device 1. For example, the electrode layer 15 may be electrically connected to an electrical terminal of the power diode device 1.

The electrode layer 13 (or referred to as the second electrode layer 13) may be located on the top surface of the substrate 10. For example, the electrode layer 13 may be disposed on the surface 112 of the heavily doped region 11. For example, the electrode layer 13 may be in contact with or cover a portion of the heavily doped region 11. For example, the electrode layer 13 may be in contact with or cover a portion of the isolation structure 12. The electrode layer 13 may be regarded as an electrical terminal of the power diode device 1. For example, the electrode layer 13 may be electrically connected to an electrical terminal of the power diode device 1. The substrate 10 may be sandwiched between the electrode layer 15 and the electrode layer 13.

In some embodiments, when viewed from the cross-sectional view, the width of the electrode layer 15 may be greater than the width of the electrode layer 13. In some embodiments, the total surface area of the electrode layer 15 may be greater than the total surface area of the electrode layer 13.

In some embodiments, the electrode layer 15 and the electrode layer 13 may include copper (Cu), gold (Au), silver (Ag), aluminum (Al), nickel (Ni), titanium (Ti), tungsten (W), Tin (Sn), or other metals or alloys. In some embodiments, the electrode layer 15 and the electrode layer 13 may include the same material, such as aluminum. In some embodiments, the electrode layer 15 and the electrode layer 13 may include different materials, for example, the electrode layer 15 is aluminum, and the electrode layer 13 is silver, nickel, or titanium.

A passivation layer 14 may be located on the top surface of the substrate 10. For example, the passivation layer 14 may be disposed on the surface 112 of the heavily doped region 11. For example, the passivation layer 14 may be disposed on the surface 10c2 of the diffusion layer 10c. For example, the passivation layer 14 may be in contact with or cover a portion of the surface 112 of the heavily doped region 11. For example, the passivation layer 14 may be in contact with or cover a portion of the surface 10c2 of the diffusion layer 10c. For example, the passivation layer 14 may completely cover the surface 10c2 of the diffusion layer 10c. For example, the passivation layer 14 may be in contact with or cover a portion of the isolation structure 12.

In some embodiments, the passivation layer 14 may surround the electrode layer 13. For example, when viewed from the cross-sectional view, the electrode layer 13 may be located between the two passivation layers 14 on the left side and right side. In some embodiments, the passivation layer 14 and the electrode layer 13 may be coplanar. However, in other embodiments, the passivation layer 14 and the electrode layer 13 may not be coplanar. For example, the edges of the passivation layer 14 may be covered by the electrode layer 13. For example, in the direction from the top surface of the substrate 10 to the bottom surface of the substrate 10, the passivation layer 14 and the electrode layer 13 may overlap each other.

In some embodiments, the diffusion layer 10c may serve as a reduced surface field (RESURF) layer. For example, the diffusion layer 10c may have a more uniform electric field distribution to increase the breakdown voltage of the power diode device 1.

In some embodiments, the diffusion layer 10c and the core layer 10b may serve as a depletion extension region DR. The diffusion layer 10c and the core layer 10b may relax the electric field originally concentrated between the heavily doped region 11 and the isolation structure 12. For example, since the impurity doping concentration of the diffusion layer 10c and the core layer 10b is lower than that of the isolation structure 12, when the power diode device 1 is reversely biased, the carriers in the diffusion layer 10c and the core layer 10b will be depleted, and the depleted extended region DR will become wider, thereby increasing the breakdown voltage of the power diode device 1. In other words, according to different voltage withstand requirements, the length of the diffusion layer 10c may be adjusted in order to relax the electric field intensity.

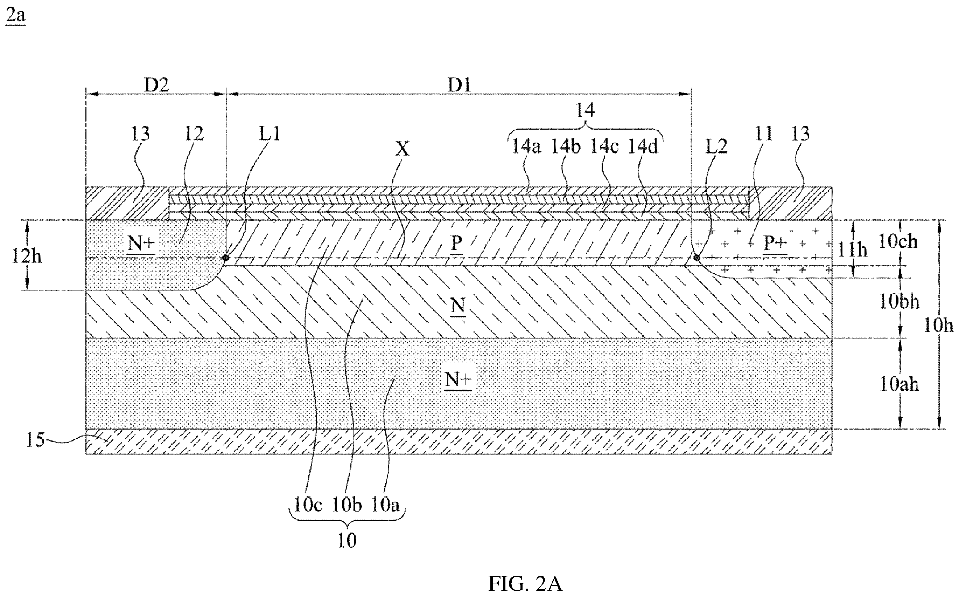

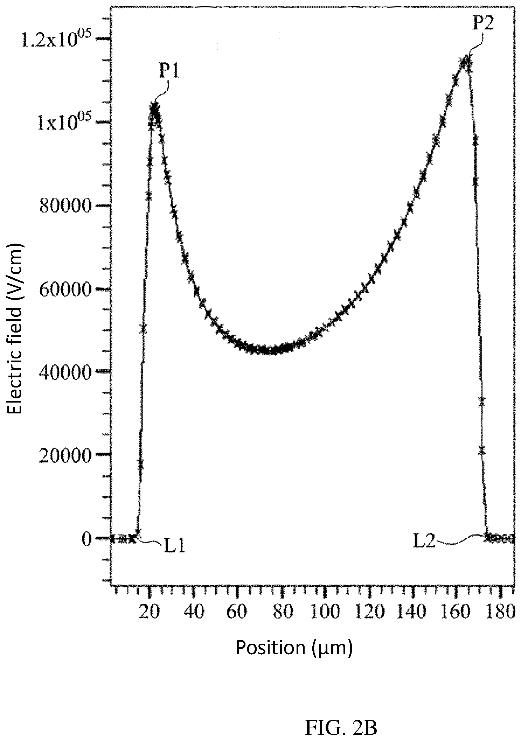

FIG. 2A shows an enlarged view of a portion of the power diode device 1. Specifically, FIG. 2A depicts a portion 2a of the power diode device in FIG. 1. The same or similar components in FIG. 2 and FIG. 1 are indicated using the same symbol, and the detailed description of these components will not be repeated.

In some embodiments, the thickness 10h of the substrate 10 may be between about 240 micrometers (µm) and about 280 µm, e.g., may be about 260 µm. In some embodiments, the thickness 10ah of the diffusion layer 10a may be between about 110 µm and about 150 µm, e.g., about 130 µm. In some embodiments, the thickness 10bh of the core layer 10b may be between about 80 µm and about 120 µm, e.g., about 100 µm. In some embodiments, the thickness lOch of the diffusion layer 10c may be between about 10 µm and about 50 µm, e.g., about 30 µm.

In some embodiments, the thickness lOch of the diffusion layer 10c may be different from the thickness 10bh of the core layer 10b. For example, the thickness lOch of the diffusion layer 10c may be smaller than the thickness 10bh of the core layer 10b. For example, the thickness 10bh of the core layer 10b may be more than three times the thickness lOch of the diffusion layer 10c.

In some embodiments, the thickness lOch of the diffusion layer 10c may be different from the thickness 10ah of the diffusion layer 10a. For example, the thickness lOch of the diffusion layer 10c may be smaller than the thickness 10ah of the diffusion layer 10a. For example, the thickness 10ah of the diffusion layer 10a may be more than four times the thickness lOch of the diffusion layer 10c.

In some embodiments, the depth 11h of the heavily doped region 11 may be between about 10 µm and about 50 µm, e.g., about 30 µm. In some embodiments, the depth 12h of the isolation structure 12 may be between about 30 µm and about 70 µm, e.g., about 50 µm. In some embodiments, the depth 12h of the isolation structure 12 may be greater than the depth 11h of the heavily doped region 11. For example, the isolation structure 12 and the heavily doped region 11 may be diffused simultaneously (e.g., as shown in FIG. 3F), and the carrier diffusion speed of the isolation structure 12 may be faster than that of the heavily doped region 11.

In some embodiments, the depth 11h of the heavily doped region 11 and the thickness lOch of the diffusion layer 10c may be approximately equal. In some embodiments, the depth 11h of the heavily doped region 11 may be greater than the thickness lOch of the diffusion layer 10c. In some embodiments, making the thickness lOch of the diffusion layer 10c smaller than the thickness 10bh of the core layer 10b may increase the process cost. However, by controlling the thickness 10ch of the diffusion layer 10c to be between about 10 µm and about 50 µm (e.g., about 30 µm), so that the heavily doped region 11 may be diffused into the core layer 10b, the surge capacity of the power diode device 1 can be improved.

In some embodiments, the distance D1 between the heavily doped region 11 and the isolation structure 12 may be between about 160 µm and about 140 µm, for example, about 150 µm. In some embodiments, the breakdown voltage may be adjusted by adjusting the distance D1. The higher the required breakdown voltage is, the larger the distance D1 needs to be. In some embodiments, the isolation structures 12 may serve as cutting routes. In some embodiments, the distance D2 of the isolation structure 12 may be approximately 2.5 mil or 63.5 µm.

In some embodiments, the passivation layer 14 may include a laminated structure having a plurality of layers. For example, the passivation layer 14 may include an oxide layer 14a, a nitride layer 14b, an oxide layer 14c, and an insulating layer 14d. The oxide layer 14a and the oxide layer 14c may include a low temperature oxide (LTO) layer. The oxide layer 14a and the oxide layer 14c may be configured as stress buffer layers. The nitride layer 14b may include silicon nitride (Si₃N₄). The nitride layer 14b may be configured as a moisture or pollution barrier. The insulating layer 14d may include a semi-insulating polycrystalline silicon (SIPOS) layer. The insulating layer 14d may be configured to remove surface charges, for example, to prevent carriers from accumulating on the surface of the power diode device to generate leakage current.

FIG. 2B shows a curve of an electric field intensity of the portion 2a of the power diode device along the line X-X in FIG. 2A. The X-axis represents the positions along the line X-X, and the unit is µm; the Y-axis represents the electric field intensity, and the unit is volt/meter (V/m). The position L1 in FIG. 2B corresponds to the position L1 in FIG. 2A, and the position L2 in FIG. 2B corresponds to the position L2 in FIG. 2A. The electric field peak value P1 is 1.05×10⁵ V/m, and its position is close to the junction between the isolation structure 12 and the diffusion layer 10c. The electric field peak value P2 is 1.2×10⁵ V/m, and its position is close to the junction between the diffusion layer 10c and the heavily doped region 11. The electric field peak value P2 is greater than the electric field peak value P1. That is, the electric field close to the junction between the diffusion layer 10c and the heavily doped region 11 is greater than the electric field close to the junction between the isolation structure 12 and the diffusion layer 10c.

The above-mentioned embodiments relate to power diode devices made of N-type monocrystalline silicon wafers. It should be known that power diode devices made of P-type monocrystalline silicon wafers with opposite doping types are also within the protection scope of the present disclosure. In one embodiment, the first conductivity type refers to doping with N-type impurities, and the second conductivity type refers to doping with P-type impurities. In another embodiment, the first conductivity type refers to doping with P-type impurities, and the second conductivity type refers to doping with N-type impurities.

Referring to FIG. 3A to FIG. 3G, FIG. 3A to FIG. 3G are schematic diagrams of an embodiment manufacturing method of a power diode device 1. Similar to FIG. 2A, in the embodiments of FIG. 3A to FIG. 3G, the structures of the portion 2a of the power diode device in FIG. 1 in various stages are used for exemplary illustration. Therefore, the same or similar components in FIG. 3A to FIG. 3G and FIG. 1 are marked with the same symbol, and the detailed description of these components will not be repeated. At least some of these drawings have been simplified to facilitate a better understanding of aspects of the present disclosure.

Referring to FIG. 3A, the manufacturing method includes forming a diffusion layer 10a in a substrate 10. The substrate 10 may include a semiconductor substrate doped with N-type or P-type impurities. In the embodiments shown from FIG. 3A to FIG. 3G and in the following descriptions, an N-type silicon wafer is used as the substrate 10, as an example. In some embodiments, the thickness 10h' of the substrate 10 may be between about 480 µm and about 520 µm. In some embodiments, an N-type silicon wafer with a volume resistivity between about 45 and about 60 Ohm-cm may be used.

In some embodiments, a backside diffusion technique may be used to diffuse the N-type impurities from the bottom surface of the substrate 10. For example, phosphor paper may be attached to the bottom surface of the substrate 10 and then diffusion is performed, so as to advance the diffusion boundary and form a deeper N+ layer. In some embodiments, diffusion may be performed at a temperature of about 1280 °C (Celsius) for about 22 hours. In some embodiments, the thickness 10ah of the diffusion layer 10a may be between about 110 µm and about 150 µm, e.g., about 130 µm. The remaining portion of the substrate 10 may be used to form the core layer 10b. In some embodiments, the surface 10a1 of the diffusion layer 10a may form the bottom surface of the substrate 10, and a diffusion boundary (located at the same position as the surface 10b1 of the core layer 10b) may be formed between the diffusion layer 10a and the core layer 10b. In other embodiments, a gaseous or liquid N-type impurity diffusion source may also be used.

In other embodiments, a double-side diffusion technology may be used to diffuse N-type impurities from the top and bottom surfaces of the substrate 10. A N+/N/N+ structure may be formed after the substrate 10 is diffused from both surfaces. The remaining portion of the substrate 10 may be used to form the core layer 10b. For example, the core layer 10b may be sandwiched by the upper and lower diffusion layers having higher impurity concentrations.

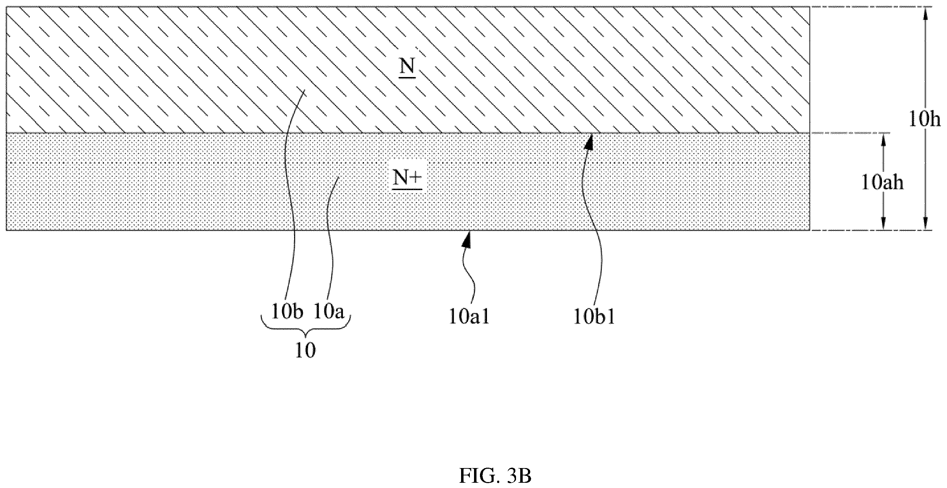

Referring to FIG. 3B, the manufacturing method may include grinding and polishing the substrate 10, and removing a portion of the core layer 10b, such that the thickness 10h of the substrate 10 is reduced to between about 240 µm and about 280 µm, e.g., about 260 µm.

In other embodiments, when N-type impurities are diffused from the top and bottom surfaces of the substrate 10 using the double-sided diffusion technology, the manufacturing method may include grinding and polishing the substrate 10 to remove one diffusion layer to expose the core layer 10b, and to reduce the thickness 10h of the substrate 10 to between about 240 µm and about 280 µm, e.g., about 260 µm.

Referring to FIG. 3C, the manufacturing method may include forming a diffusion layer 10c in the substrate 10. Taking boron as an example, liquid source diffusion, solid source diffusion or ion implantation may be used to invert a portion of the core layer 10b from N-type to P-type. In some embodiments, the ion implantation method may be used. In some embodiments, the diffusion layer 10c may be formed through annealing, oxidation, and diffusion. In some embodiments, before forming the diffusion layer 10c, an oxide layer may be formed on the core layer 10b as a buffer layer, to avoid generating defects during the ion implantation. In some embodiments, the surface 10c2 of the diffusion layer 10c may form the top surface of the substrate 10, and a diffusion boundary (located at the same position as the surface 10b2' of the core layer 10b) may be formed between the diffusion layer 10c and the core layer 10b.

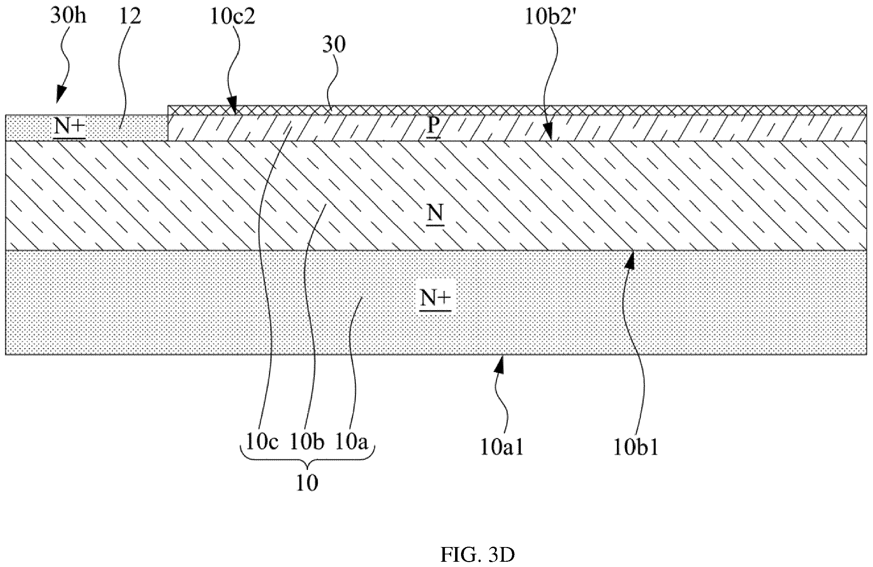

Referring to FIG. 3D, the manufacturing method may include forming an isolation structure 12 in the substrate 10. In some embodiments, a protective layer 30, such as a mask or a photomask, may be formed on the surface 10c2 of the diffusion layer 10c. An opening 30h may be formed in the protective layer 30 to define a location where the isolation structure 12 is formed. In some embodiments, using phosphorus as an example, phosphorus oxychloride (POCl₃) may be used as the phosphorus source for pre-deposition. Afterwards, main diffusion may be performed on the pre-deposited substrate 10 to advance the diffusion boundary and form a deeper N+ layer. Same as the diffusion layer 10a, the isolation structure 12 may permeate through phosphor paper, or gaseous or liquid N-type impurity diffusion sources.

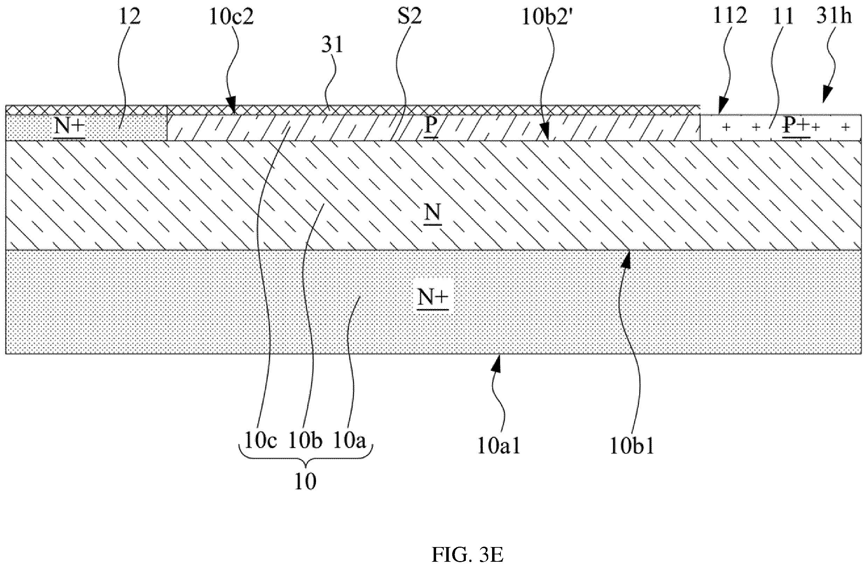

Referring to FIG. 3E, the manufacturing method may include forming a heavily doped region 11 in the substrate 10. In some embodiments, the protective layer 30 may be removed. The protective layer 30 may be removed by using etching, stripping or other suitable processes. A protective layer 31, such as a mask or photomask, may be formed on the surface 10c2 of the diffusion layer 10c. An opening 31h may be formed in the protective layer 31 to define a position where the heavily doped region 11 is formed. In some embodiments, using boron as an example, boron trichloride (BCl₃) may be used as the boron source for pre-deposition. Afterwards, main diffusion is performed on the pre-deposited substrate 10 to advance the diffusion boundary and form a deeper P+ layer. The heavily doped region 11 may include a surface 112. In some embodiments, the surface 112 may be coplanar with the surface 10c2. The surface 112 may be coplanar with the top surface of the substrate 10.

Referring to FIG. 3F, the manufacturing method may include diffusing the heavily doped region 11 toward the core layer 10b. In some embodiments, the heavily doped region 11 may be diffused toward the core layer 10b, such that one surface of the heavily doped region 11 can reach the surface 10b2 of the core layer 10b or reach in-between the surface 10b2 and the surface 10b 1 of the core layer 10b without reaching the surface 10b1. In some embodiments, the heavily doped region 11 may be diffused toward the core layer 10b to form a PN junction S1 between the heavily doped region 11 and the core layer 10b.

In some embodiments, the protective layer 31 may be removed. The protective layer 31 may be removed by using etching, stripping or other suitable processes. A protective layer 32, such as a mask or photomask, may be formed on the surface 10c2 of the diffusion layer 10c and the surface 112 of the heavily doped region 11. In some embodiments, diffusion may be performed at a temperature of about 1250 °C for about 15 hours.

In some embodiments, the diffusion layer 10c and the heavily doped region 11 may be diffused simultaneously. For example, the diffusion layer 10c and the heavily doped region 11 may be formed in the same step. In some embodiments, the diffusion layer 10c may be diffused toward the core layer 10b, and a surface 10b2' between the diffusion layer 10c and the core layer 10b (as shown in FIG. 3E) moves downward to become the surface 10b2, which may form a PN junction S2.

In some embodiments, the PN junction S2 and the PN junction S1 may be continuous junctions. In some embodiments, the PN junction S1 protrudes over the PN junction S2 in the direction from the top surface of the substrate 10 to the bottom surface of the substrate 10.

In some embodiments, the isolation structure 12 and the heavily doped region 11 may be diffused simultaneously. For example, the isolation structure 12 and the heavily doped region 11 may be formed in the same step. In some embodiments, the isolation structure 12 may be diffused toward the core layer 10b, and one surface thereof may reach the surface 10b2 of the core layer 10b or reach in-between the surface 10b2 and the surface 10b1 of the core layer 10b but not reach the surface 10b1. In some embodiments, the carrier diffusion speed of the isolation structure 12 may be faster than that of the heavily doped region 11, and thus the depth 12h of the isolation structure 12 may be greater than the depth 11h of the heavily doped region 11.

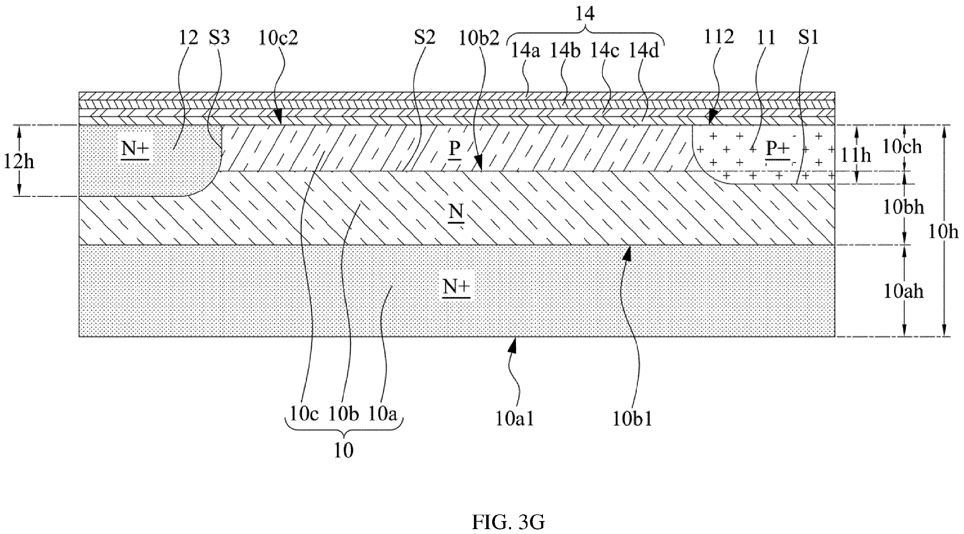

Referring to FIG. 3G, the manufacturing method may include forming a passivation layer 14 on the top surface of the substrate 10. In some embodiments, the protective layer 32 may be removed. The protective layer 32 may be removed by using etching, stripping or any other suitable processes.

Thereafter, an electrode layer 13 and an electrode layer 15 may be formed on the top and bottom surfaces of the substrate 10, respectively, by using a metal mask (not shown). In some embodiments, the electrode layer 13 and the electrode layer 15 may be formed by using sputtering, electroless plating, electroplating, printing or other suitable processes. The metal mask may be removed by using etching, stripping or other suitable processes. The semiconductor structure formed through the above steps may be the similar to the portion 2a of the power diode device in FIG. 2A.

The embodiment manufacturing method of the power diode device may use an N-type (or P-type) monocrystalline silicon wafer to form the diffusion layer 10c. Compared with using an epitaxial layer, the cost of forming the diffusion layer 10c can be lower. In addition, during the diffusion process, the thickness lOch of the diffusion layer 10c can be controlled to not exceed 50 µm or not exceed 30 µm, such that the heavily doped region 11 can be easily diffused into the core layer 10b, and the surge capability of the power diode device 1 is improved.

Furthermore, the embodiment manufacturing method of the power diode device uses three photomasks. Compared with the power diode device manufacturing method that forms guard rings to relax the electric field distribution (usually requires at least 4 photomasks), the embodiment uses fewer photomasks, and thus the manufacturing process is simplified and the cost is lower.

In this disclosure, for description convenience, spatially relative terms such as "below", "under", "lower", "above", "upper", "left side", "right side", and so on, may be used to describe the relationship of one component or feature with another one or more components or features, as shown in the accompanying drawings. The spatially relative terms are not only used to depict the orientations in the accompanying drawings, but also intended to encompass different orientations of the device in use or operation. A device may be oriented in other ways (rotated 90 degrees or at other orientations), and the spatially relative terms used herein may be interpreted in a corresponding way similarly. It should be understood that when a component is referred to as being "connected" or "coupled" to another component, it can be directly connected or coupled to another component or an intervening component may be present.

As used herein, the terms "approximately", "basically", "substantially" and "about" are used to describe and account for small variations. When used in conjunction with an event or instance, the terms may refer to an embodiment of exact occurrence of an event or instance as well as an embodiment where the event or instance is close to the occurrence. As used herein with respect to a given value or range, the term "about" generally means being within ±10%, ±5%, ±1%, or ±0.5% of the given value or range. A range herein may be referred to as being from one endpoint to the other or as being between two endpoints. All ranges disclosed herein are inclusive of endpoints unless otherwise indicated. The term "substantially coplanar" may mean that the difference of positions of two surfaces with reference to the same plane is within a few micrometers (µm), e.g., within 10 µm, within 5 µm, within 1 µm, or within 0.5 µm. When values or characteristics are referred to as being "substantially" the same, the term may refer to a value that is within ±10%, ±5%, ±1%, or ±0.5% of the mean of the values.

The foregoing has outlined features of several embodiments and detailed aspects of present disclosure. The embodiments described in the present disclosure may be readily used as a basis for designing or modifying other processes and structures in order to carry out the same or similar purposes and/or to achieve the same or similar advantages of the embodiments presented herein. Such equivalent constructions do not depart from the spirit and scope of the present disclosure, and various changes, substitutions, and alterations can be made without departing from the spirit and scope of the present disclosure.

Moreover, the scope of the disclosure is not intended to be limited to the particular embodiments described herein, as one of ordinary skill in the art will readily appreciate from this disclosure that processes, machines, manufacture, compositions of matter, means, methods, or steps, presently existing or later to be developed, may perform substantially the same function or achieve substantially the same result as the corresponding embodiments described herein. Accordingly, the appended claims are intended to include within their scope such processes, machines, manufacture, compositions of matter, means, methods, or steps.

In addition to or as an alternative to the above, the following examples are described. The features described in any of the following examples may be utilized with any of the other examples described herein.
Example 1. A power diode device comprising a substrate, the substrate comprising:
   a first diffusion layer of a first conductivity type, the first diffusion layer comprising a first surface and a second surface opposite to each other, and the first surface of the first diffusion layer forming a bottom surface of the substrate;
   a second diffusion layer of a second conductivity type, the second diffusion layer comprising a first surface and a second surface opposite to each other, and the second surface of the second diffusion layer forming a top surface of the substrate;
   a core layer of the first conductivity type between the first diffusion layer and the second diffusion layer, the core layer comprising a first surface and a second surface opposite to each other, the first surface of the core layer facing the first diffusion layer, the second surface of the core layer facing the second diffusion layer, and a thickness of the core layer being greater than a thickness of the second diffusion layer; and
   a heavily doped region of the second conductivity type in the second diffusion layer and extending toward the core layer, the heavily doped region comprising a first surface and a second surface opposite to each other, the second surface of the heavily doped region being coplanar with the second surface of the second diffusion surface, the first surface of the heavily doped region reaching the second surface of the core layer or reaching in-between the first surface of the core layer and the second surface of the core layer without reaching the first surface of the core layer, with a first PN junction formed between the heavily doped region and the core layer.
Example 2. The power diode device of example 1, wherein a second PN junction is formed between the core layer and the second diffusion layer, the first PN junction and the second PN junction forming a continuous junction.
Example 3. The power diode device of example 2, wherein the first PN junction protrudes over the second PN junction in a direction from the top surface of the substrate to the bottom surface of the substrate.
Example 4. The power diode device of any one of examples 1 to 3, wherein the substrate further comprises: an isolation structure surrounding the heavily doped region, the isolation structure being separated from the heavily doped region by the second diffusion layer.
Example 5. The power diode device of example 4, wherein a depth of the isolation structure is greater than a depth of the heavily doped region.
Example 6. The power diode device of any one of examples 1 to 5, further comprising: a first electrode layer, disposed on the bottom surface of the substrate and in contact with the first diffusion layer; and a second electrode layer, disposed on the top surface of the substrate and in contact with the heavily doped region.
Example 7. The power diode device of example 6, further comprising: a passivation layer, disposed on the top surface of the substrate and in contact with the heavily doped region, the passivation layer surrounding the second electrode layer.
Example 8. The power diode of any one of examples 1 to 7, wherein a second PN junction is formed between the second diffusion layer and the core layer, and a third PN junction is formed between the isolation structure and the second diffusion layer.
Example 9. A method for making a power diode, comprising:
   forming a first diffusion layer of a first conductivity type in a substrate of the first conductivity type, the first diffusion layer comprising a first surface and a second surface opposite to each other, and the first surface of the first diffusion layer forming a bottom surface of the substrate;
   forming a second diffusion layer of a second conductivity type in the substrate, with a core layer located between the second diffusion layer and the first diffusion layer, the second diffusion layer comprising a first surface and a second surface opposite to each other, and the second surface of the second diffusion layer forming a top surface of the substrate;
   forming a heavily doped region of the second conductivity type in the second diffusion layer, the heavily doped region comprising a first surface and a second surface opposite to each other, and the second surface of the heavily doped region being coplanar with the top surface of the substrate; and
   diffusing the heavily doped region into the core layer to form a first PN junction between the heavily doped region and the core layer.
Example 10. The method of example 9, wherein forming the second diffusion layer comprises: converting a portion of the substrate from the first conductivity type to the second conductivity type to form the second diffusion layer.
Example 11. The method of example 9 or 10, wherein diffusing the heavily doped contact region into the core layer comprises: diffusing, simultaneously, the second diffusion layer and the heavily doped region into the core layer to form a second PN junction between the core layer and the second diffusion layer.
Example 12. The method of example 11, wherein diffusing the heavily doped contact region into the core layer further comprises: diffusing the heavily doped region toward the core layer such that the first surface of the heavily doped region reaches the second PN junction or reaches beyond the second PN junction.
Example 13. The method of example 11 or 12, wherein the first PN junction and the second PN junction form a continuous junction.
Example 14. The method of any one of examples 9 to 13, further comprising: forming an isolation structure of the first conductivity type in the second diffusion layer.
Example 15. The method of example 14, wherein the isolation structure is formed before the heavily doped region is formed.
Example 16. The method of example 14 or 15, wherein diffusing the heavily doped contact region into the core layer comprises: diffusing, simultaneously, the isolation structure and the heavily doped region into the core layer.
Example 17. The method of example 16, wherein diffusing, simultaneously, the isolation structure and the heavily doped region into the core layer comprises: diffusing the isolation structure and the heavily doped region into the core layer such that a depth of the isolation structure is greater than a depth of the heavily doped region.
Example 18. The method of any one of examples 14 to 17, further comprising: forming a passivation layer on the top surface of the substrate, the passivation layer in contact with the isolation structure and the heavily doped region.
Example 19. The method of any one of examples 9 to 18, further comprising: forming a first electrode layer on the bottom surf ace of the substrate, the first electrode layer in contact with the first diffusion layer; and forming a second electrode layer on the top surface of the substrate, the second electrode layer in contact with the heavily doped region.
Example 20. A power diode comprising:
   a first diffusion layer of a first conductivity type in a substrate, the first diffusion layer comprising a first surface and a second surface opposite to each other, and the first surface of the first diffusion layer being a bottom surface of the substrate;
   a second diffusion layer of a second conductivity type in the substrate, the second diffusion layer comprising a first surface and a second surface opposite to each other, and the second surface of the second diffusion layer being a top surface of the substrate;
   a core layer of the first conductivity type between the first diffusion layer and the second diffusion layer, the core layer comprising a first surface and a second surface opposite to each other, the first surface of the core layer facing the first diffusion layer, and the second surface of the core layer facing the second diffusion layer;
   a heavily doped region of the second conductivity type in the second diffusion layer, the heavily doped region extending into the core layer without reaching the first surface of the core layer, with a first PN junction formed between the heavily doped region and the core layer; and
   an isolation structure separated from the heavily doped region by the second diffusion layer.
Example 21. The power diode of example 20, wherein a second PN junction is formed between the second diffusion layer and the core layer, and a third PN junction is formed between the isolation structure and the second diffusion layer.
Example 22. The power diode device of example 20 or 21, wherein a second PN junction is formed between the core layer and the second diffusion layer, the first PN junction and the second PN junction forming a continuous junction.
Example 23. The power diode device of example 22 or 23, wherein the first PN junction protrudes over the second PN junction in a direction from the top surface of the substrate to the bottom surface of the substrate.
Example 24. The power diode device of any one of examples 20 to 23, wherein a depth of the isolation structure is greater than a depth of the heavily doped region.
Example 25. The power diode device of any one of examples 20 to 24, further comprising: a first electrode layer, disposed on the bottom surface of the substrate and in contact with the first diffusion layer; and a second electrode layer, disposed on the top surface of the substrate and in contact with the heavily doped region.
Example 26. The power diode device of example 25, further comprising: a passivation layer, disposed on the top surface of the substrate and in contact with the heavily doped region, the passivation layer surrounding the second electrode layer.

## Claims

1. A power diode device comprising a substrate, the substrate comprising:
a first diffusion layer of a first conductivity type, the first diffusion layer comprising a first surface and a second surface opposite to each other, and the first surface of the first diffusion layer forming a bottom surface of the substrate;
a second diffusion layer of a second conductivity type, the second diffusion layer comprising a first surface and a second surface opposite to each other, and the second surface of the second diffusion layer forming a top surface of the substrate;
a core layer of the first conductivity type between the first diffusion layer and the second diffusion layer, the core layer comprising a first surface and a second surface opposite to each other, the first surface of the core layer facing the first diffusion layer, the second surface of the core layer facing the second diffusion layer, and a thickness of the core layer being greater than a thickness of the second diffusion layer; and
a heavily doped region of the second conductivity type in the second diffusion layer and extending toward the core layer, the heavily doped region comprising a first surface and a second surface opposite to each other, the second surface of the heavily doped region being coplanar with the second surface of the second diffusion surface, the first surface of the heavily doped region reaching the second surface of the core layer or reaching in-between the first surface of the core layer and the second surface of the core layer without reaching the first surface of the core layer, with a first PN junction formed between the heavily doped region and the core layer.

2. The power diode device of claim 1, wherein a second PN junction is formed between the core layer and the second diffusion layer, the first PN junction and the second PN junction forming a continuous junction.

3. The power diode device of claim 2, wherein the first PN junction protrudes over the second PN junction in a direction from the top surface of the substrate to the bottom surface of the substrate.

4. The power diode device of any preceding claim, wherein the substrate further comprises:
an isolation structure surrounding the heavily doped region, the isolation structure being separated from the heavily doped region by the second diffusion layer; and optionally:
wherein a depth of the isolation structure is greater than a depth of the heavily doped region.

5. The power diode device of any preceding claim, further comprising:
a first electrode layer, disposed on the bottom surface of the substrate and in contact with the first diffusion layer; and
a second electrode layer, disposed on the top surface of the substrate and in contact with the heavily doped region; and optionally:
further comprising: a passivation layer, disposed on the top surface of the substrate and in contact with the heavily doped region, the passivation layer surrounding the second electrode layer.

6. A method for making a power diode, comprising:
forming a first diffusion layer of a first conductivity type in a substrate of the first conductivity type, the first diffusion layer comprising a first surface and a second surface opposite to each other, and the first surface of the first diffusion layer forming a bottom surface of the substrate;
forming a second diffusion layer of a second conductivity type in the substrate, with a core layer located between the second diffusion layer and the first diffusion layer, the second diffusion layer comprising a first surface and a second surface opposite to each other, and the second surface of the second diffusion layer forming a top surface of the substrate;
forming a heavily doped region of the second conductivity type in the second diffusion layer, the heavily doped region comprising a first surface and a second surface opposite to each other, and the second surface of the heavily doped region being coplanar with the top surface of the substrate; and
diffusing the heavily doped region into the core layer to form a first PN junction between the heavily doped region and the core layer.

7. The method of claim 6, wherein forming the second diffusion layer comprises: converting a portion of the substrate from the first conductivity type to the second conductivity type to form the second diffusion layer.

8. The method of claim 6 or 7, wherein diffusing the heavily doped contact region into the core layer comprises:
diffusing, simultaneously, the second diffusion layer and the heavily doped region into the core layer to form a second PN junction between the core layer and the second diffusion layer.

9. The method of claim 8, wherein:
diffusing the heavily doped contact region into the core layer further comprises: diffusing the heavily doped region toward the core layer such that the first surface of the heavily doped region reaches the second PN junction or reaches beyond the second PN junction; and/or
the first PN junction and the second PN junction form a continuous junction.

10. The method of claim any one of claims 6 to 9, further comprising:
forming an isolation structure of the first conductivity type in the second diffusion layer.

11. The method of claim 10:
wherein the isolation structure is formed before the heavily doped region is formed; and/or
further comprising: forming a passivation layer on the top surface of the substrate, the passivation layer in contact with the isolation structure and the heavily doped region

12. The method of claim 10 or 11, wherein diffusing the heavily doped contact region into the core layer comprises:
diffusing, simultaneously, the isolation structure and the heavily doped region into the core layer; and optionally:
wherein diffusing, simultaneously, the isolation structure and the heavily doped region into the core layer comprises: diffusing the isolation structure and the heavily doped region into the core layer such that a depth of the isolation structure is greater than a depth of the heavily doped region.

13. The method of any one of claims 6 to 12, further comprising:
forming a first electrode layer on the bottom surface of the substrate, the first electrode layer in contact with the first diffusion layer; and
forming a second electrode layer on the top surface of the substrate, the second electrode layer in contact with the heavily doped region.

14. A power diode comprising:
a first diffusion layer of a first conductivity type in a substrate, the first diffusion layer comprising a first surface and a second surface opposite to each other, and the first surface of the first diffusion layer being a bottom surface of the substrate;
a second diffusion layer of a second conductivity type in the substrate, the second diffusion layer comprising a first surface and a second surface opposite to each other, and the second surface of the second diffusion layer being a top surface of the substrate;
a core layer of the first conductivity type between the first diffusion layer and the second diffusion layer, the core layer comprising a first surface and a second surface opposite to each other, the first surface of the core layer facing the first diffusion layer, and the second surface of the core layer facing the second diffusion layer;
a heavily doped region of the second conductivity type in the second diffusion layer, the heavily doped region extending into the core layer without reaching the first surface of the core layer, with a first PN junction formed between the heavily doped region and the core layer; and
an isolation structure separated from the heavily doped region by the second diffusion layer.

15. The power diode of claim 14, wherein a second PN junction is formed between the second diffusion layer and the core layer, and a third PN junction is formed between the isolation structure and the second diffusion layer.
